# EUROPEAN PATENT APPLICATION

(11) **EP 4 510 403 A1**
(43) Date of publication of application: **19.02.2025**
(21) Application number: 23191260.1
(22) Date of filing: 14.08.2023
(51) Int. Cl.: H02J 1/08, H02J 1/10

(54) **REDUNDANT POWER SUPPLY**

(71) Applicant: Aptiv Technologies AG, 8200 Schaffhausen (CH)
(72) Inventor: ROSENTHAL, Thorsten, 45468 Mülheim an der Ruhr (DE); YOUSEF, Sebastian, 44795 Bochum (DE); FUCHS, Andreas, 51067 Köln (DE); KNAGA, Tomasz, 32-765 Rzezawa, Malopolska (PL); FAISAL, Mian Shah, 30-057 Krakow (PL)
(74) Representative: Bardehle Pagenberg Partnerschaft mbB Patentanwälte Rechtsanwälte

(57) **Abstract**

The present invention relates to an electrical power supply circuit (1) comprising at least two power supply branches (2a, 2b), wherein each power supply branch (2a, 2b) comprises: a first semiconductor switch (3a, 3b) configured to be electrically connected to a power source; a second semiconductor switch (4a, 4b) in series with the first semiconductor switch (3a, 3b) and electrically connected to a common output (3) of the electrical supply circuit (1); and a first resistor (5a, 5b), wherein a first end of the first resistor (5a, 5b) is electrically connected to the electrical connection between the first semiconductor switch (3a, 4b) and the second semiconductor switch (4a, 4b) and a second end of the first resistor (5a, 5b) is configured to be electrically connected to a reference potential.

## Description

### Technical field

The present invention relates to an electrical power supply circuit, in particular for automotive applications.

### Technical background

Redundant power supplies are used in variety of applications ranging from critical computer systems to vehicles. The basis of a redundant power supply are two or more power sources connected in parallel. Even in case of a failure of one of the power sources, the other power source(s) would still be able to supply power to a load connected to the redundant power supply. In this way, redundancy improves the robustness, fail-safety and availability.

However, what is needed is a way to monitor the status of a redundant power supply itself and to be able to detect a possible failure in one of its branches in order to initiate corresponding measures. At the same time, such additional safety measures shall be implemented with a minimum of additional components to reduce complexity and costs. Also, for certain applications, a redundant power supply should be able to provide high currents to external loads.

### Summary of the Invention

The present invention addresses those needs by the subject matter of the independent claims. Advantageous embodiments are defined in the dependent claims.

Accordingly, in a first aspect, the present invention relates to an electrical power supply circuit comprising at least two power supply branches, wherein each power supply branch comprises: a first semiconductor switch configured to be electrically connected to a power source; a second semiconductor switch in series with the first semiconductor switch and electrically connected to a common output of the electrical supply circuit; and a first resistor, wherein a first end of the first resistor is electrically connected to the connection between the first semiconductor switch and the second semiconductor switch and a second end of the first resistor is configured to be electrically connected to a reference potential.

The semiconductor switches allow to disconnect a particular power supply branch from the common output of the power supply circuit. This can be done for diagnosing and testing purposes as will be described in more detail below. In addition, it allows disconnecting a faulty power supply branch from the common output such that the remaining faultless branch can still supply power to the common output and connected loads. Furthermore, in certain situations, it is possible to switch off all power supply branches to meet certain safety goals, such as avoiding reverse currents from flowing into the electrical power supply circuit. Finally, semiconductor switches such as field effect transistors (FETs) may be provided with a low on-resistance (R_{DS(on)}) such as for example 1 mΩ which allows for high currents flowing through the power supply branches at low internal thermal dissipation loss. In this way, voltage can be provided to high-power external loads.

At the same time, one end of a resistor in each power supply branch is electrically connected to the connection of the two semiconductor switches and the other end is configured to be electrically connected to a defined reference potential such as ground. In operation, if both semiconductor switches in a first power supply branch are switched off and the switches in another power supply branch are switched on, the electrical potential at the resistor is expected to match the reference potential. If the measured potential does not match the expected (reference) potential, this indicates a short-circuit fault, e.g. from drain to source, in one or both of the semiconductor switches of the switched off power supply branch. Therefore, a failure of the semiconductor switches can be detected and the electrical power supply circuit can be shut down by means of the (intact) semiconductor switches avoiding additional harm.

The electrical power supply circuit according to the invention also allows to diagnose and test whether each power supply branch individually supplies the expected voltage to the common output of the electrical power supply circuit. To this end, a first power supply branch can be switched off by means of its corresponding semiconductor switches and the other power supply branch can be switched on by its corresponding semiconductor switches. The output voltage at the common output of the electrical power supply circuit is then expected to correspond to the nominal voltage, i.e. the input voltage to the electrical power supply circuit. If this is not the case, e.g. the voltage is substantially below the nominal voltage or even at ground, this indicates a failure of one or both of the semiconductor switches of the switched on power supply branch.

In the context of the present invention, it is important that each power supply branch can be connected to one or more power sources that are independent from the power source or power sources supplying the other power supply branches. Thus, each power supply branch can independently be supplied with power and the reliability of the system is significantly increased.

Moreover, during normal operation and by appropriately controlling the states of the semiconductor switches only one power supply branch is open at the same time, i.e. providing power to the common output of the electrical supply circuit. In this way no reverse current can flow into the inactive power supply branch(es). Thus, the circuit has a "priority" power supply branch that is turned on in nominal conditions (e.g. in case of a vehicle, ignition is "on"). Only if the active power supply branch has a too low voltage, it is closed and another power supply branch is opened. In this way, a fail-over safety can be achieved. However, switching over to the inactive power supply branch for a short time is allowed for diagnostic purposes in non-critical states (e.g. in case of vehicle when the ignition is "off').

Each power supply branch may further comprise a second resistor with a first end being electrically connected to the connection between the first semiconductor switch and the second semiconductor switch and a second end being electrically connected to the common output of the electrical power supply circuit in order to form a voltage divider with the first resistor. Thus, the second resistor in the context of the present invention is optional. Using a second resistor and forming a voltage divider with the first resistor allows to adjust the expected electrical potential between the first and second semiconductor switch. For example, in case of resistors with the same resistance, the defined potential may be half of the supply voltage if the reference potential (connected to the second end of the first resistor) is ground.

The semiconductor switches may be MOSFETs. MOSFETs can switch high load currents with a comparably small control current and fast switching times. In addition, they may provide a low on-resistance (R_{DS(on)}) required to supply high-power external loads.

The first semiconductor switch and/or the second semiconductor switch may comprise overcurrent protection. For example, the semiconductor switches may shutdown if the current flowing through the switches exceeds a predetermined threshold. In this case, overheating and damages to the switches and the respective power supply branch can be avoided.

The electrical power supply circuit may further comprise a controller configured to switch the semiconductor switches, receive an electrical signal corresponding to the electrical potential at the first end of the first resistor, and/or receive an electrical signal corresponding to the electrical potential at the common output of the electrical power supply circuit. In this way, the controller can perform a self-test of the electrical power supply circuit and can switch off a faulty power supply branch or the entire electrical power supply circuit as will be described in more detail below. The controller may be a microcontroller. The controller may have an Automotive Safety Integrity Level- (ASIL)-B-qualification, more preferably an ASIL-C and most preferably an ASIL-D qualification. The electrical signals may directly correspond to the respective electrical potentials. In this case, the controller may comprise Analog-to-Digital Converters (ADCs) to transform the electrical potentials into digital representations thereof. The ADC inputs of controller may directly be connected to the respective measurement points in the circuit. Alternatively, one or more operational amplifiers and/or impedance converters may be arranged between the measurement points and the ADC inputs of the controller.

The electrical power supply circuit may further comprise a measurement unit configured to measure the electrical potential at the first end of the first resistor and/or the electrical potential at the common output of the electrical power supply circuit, wherein the measurement unit is electrically connected to the controller. The measurement unit may comprise an Analog-to-Digital Converter (ADC). The ADC may be electrically connected to the controller. In this case, the electrical signals corresponding to the electrical potentials and being fed to the controller are digital signals representing the measured electrical potentials. Using an ADC allows to map the potentials measured at the output of the semiconductor switches to be mapped to digital values which can be read by the controller for use in a control software executed at the controller.

The controller may be configured to output a failure signal and/or to set a failure flag if the electrical potential at the first end of the first resistor deviates from a first predetermined value by a first predetermined amount and/or if the electrical potential at the common output of the electrical power supply circuit (1) deviates from a second predetermined value by a second predetermined amount. In this way, a failure may be detected by the controller and corresponding measures taken. For example, a warning may be provided to a driver of a vehicle, or the vehicle may refuse to re-start if a failure is detected.

The first semiconductor switch and the second semiconductor switch may comprise a forward direction and an opposing reverse direction, wherein the forward direction of the first semiconductor switch is configured to be operated in the reverse direction and the second semiconductor switch is configured to be operated in the forward direction. Forward and rearward direction of a semiconductor switch may be defined by its bulk diode.

The electrical power supply circuit may comprise two power supply branches. This may provide a failover if one of the two power supply branches shows a failure. Using two branches substantially improves the robustness, fail-safety and availability with a minimum of additional components.

The electrical power supply circuit may be configured for an automotive application. Modern cars comprise a lot of functions being controlled by electronic control units that benefit from power supplies for the sake of safety and availability. This is in particular true for safety critical functions used for assisted and/or automated driving such as in autonomous cars.

Another aspect of the present invention relates to a method of diagnosing an electrical power supply circuit as disclosed herein, wherein the electrical power supply circuit (1) comprises at least two power supply branches. The method comprises the step of switching off the first semiconductor switch and the second semiconductor switch in the first power supply branch; switching on the first semiconductor switch and the second semiconductor switch in the second power supply branch; and measuring an electrical potential (4a) at the first end of the first resistor in the first power supply branch.

The method may further comprise the step of diagnosing a failure in the first power supply branch if the measured electrical potential at the first end of the first resistor deviates from a first predetermined value by a first predetermined amount and/or if the electrical potential at the first end of the first resistor matches a second predetermined value within a first predetermined tolerance; and switching off all semiconductor switches in response to diagnosing a failure in the first power supply branch. As such it is equivalent whether the potential deviates from a first predetermined value or whether the potential matches a second predetermined value different from the first predetermined value. For example, a failure may be diagnosed if the potential deviates from 0 V by at least 0.5 V or if it matches 12 V within a tolerance of 1 V.

The mentioned diagnosing step allows to test for a short circuit, in particular between drain and source of one of the semiconductor switches in the first power supply branch because any current flowing into this power supply branch leads to an unexpected voltage drop across the resistor. The other (second) power supply branch can be diagnosed in a similar way by changing the roles of the first and second power supply branch.

The method may further comprise the step of measuring an electrical potential at the common output of the electrical power supply circuit.

The method may further comprise the steps: diagnosing a failure in the second power supply branch if the measured electrical potential at the common output of the electrical power supply circuit deviates from a third predetermined value by a second predetermined threshold and/or if the electrical potential at the common output of the electrical power supply circuit matches a fourth predetermined value within a second predetermined tolerance; and outputting a failure signal and/or setting a failure flag in response to diagnosing a failure in the second power supply branch. As such it is equivalent whether the potential deviates from a third predetermined value or whether the potential matches a fourth predetermined value different from the third predetermined value. For example, a failure may be diagnosed if the potential deviates from 12 V by at least 0.5 V or if it matches 0 V within a tolerance of 1 V.

The mentioned diagnosing step allows to test whether the active (i.e. switched on) power supply branch properly supplies power and voltage to the common output of the power supply circuit. If this is the case, the expected potential at the common output matches the nominal supply voltage, e.g. 12 V. If this is not the case, the voltage is below the nominal voltage and a failure is diagnosed. The other (first) power supply branch can be diagnosed in a similar way by changing the roles of the first and second power supply branch.

The method may be performed for an electrical power supply circuit as described herein comprising more than two power supply branches. In this case, one of the branches is switched on and the other branches are switched off.

Another aspect of the present invention relates to a computer program comprising instructions which, when executed by a computer, cause the computer to perform a method as described herein.

### Brief Description of the Drawings

Possible embodiments of the invention are described in more detail in the following detailed description with reference to the following figure:

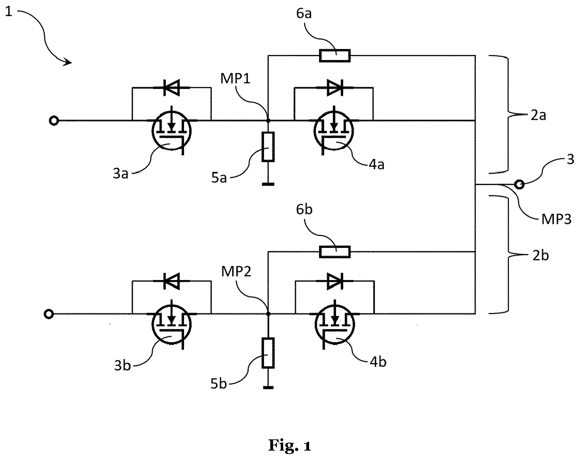

- Fig. 1: illustrates an exemplary embodiment of the present invention.

### Detailed Description of Possible Embodiments

For the sake of brevity, only a few embodiments will be described below. The person skilled in the art will recognize that the features described with reference to these specific embodiments may be modified and combined in different ways and that individual features may also be omitted. The general explanations in the sections above also apply to the more detailed explanations below.

Fig. 1 illustrates an exemplary embodiment of the present invention by way of a power supply circuit 1 comprising a first power supply branch 2a and a second power supply branch 2b being connected in parallel. As such, the power supply circuit 1 is a redundant power supply circuit. Both branches 2a and 2b are connected to a common output 3 of the electrical power supply circuit 1. A load (not shown in Fig.1) such as a motor, sensor, control unit, rear lamp or front lamp etc. may be connected to the common output 3. In the exemplary embodiment of Fig. 1 the power supply circuit 1 comprises two parallel branches, but the invention is not restricted to two branches and more branches would generally add to the robustness and fail-safety of the circuit.

In the example of Fig. 1 each power supply branch 2a, 2b comprises a first semiconductor switch 3a and 3b, respectively, comprising an input and an output. The input can be connected to a power source (not shown in Fig. 1). Thus, the semiconductor switches 3a and 3b allow the respective branch 2a and 2b to be connected to or disconnected from the power source. Each power source provides a voltage (such as e.g. 12V, 24V, 48V etc.) and a current depending on the load connected to the common output 3 of the power supply circuit 1. The power sources for the first branch 2a and the second branch 2b should be different for reasons of redundancy. In particular, it is preferable that the power sources are independent and/or free from interference for reasons of increased fail safety. The electrical connection to the power sources can be made via a plug connection, clamp, solder connection or the like.

The semiconductor switches 3a and 3b may be or comprise MOSFETs. Also, the semiconductor switches 3a and 3b may comprise high-side drivers such that the switches 3a, 3b can be controlled by a lower voltage level than the voltage that is actually switched by the switches 3a, 3b. For example, the high-side drivers may allow the switches 3a, 3b to be controlled by voltage levels found in transistor-transistor logic (TTL) or complementary metal-oxide-semiconductor (CMOS) logic. As such, operation of the switches 3a, 3b may for example be controlled by a microcontroller (not shown in Fig. 1).

Also, the semiconductor switches 3a, 3b may comprise overcurrent protection that shuts down a switch in case of overcurrent or excessive heat. For example, electronic fuses (e-fuses) may be provided as overcurrent protection. These are integrated circuits that replace larger conventional fuses or other protection devices.

In the example of Fig. 1 each branch 2a, 2b of the power supply circuit 1 also comprises a second semiconductor switch 4a and 4b, respectively. The second switches are operated in an opposite direction compared to the first switches. In the example of Fig. 1, the first semiconductor switches 3a, 3b are operated in the reverse direction and the second semiconductor switches 4a, 4b are operated in the forward direction. Reverse and forward direction are defined with respect to a bulk diode formed in the semiconductor switches.

Just like the first semiconductor switches 3a, 3b, the second semiconductor switches 4a and 4b may be or comprise MOSFETs. Also, the semiconductor switches 4a and 4b may comprise high-side drivers such that the switches 4a, 4b can be controlled by a lower voltage level than the voltage that is actually switched by the switches 4a, 4b. For example, the high-side drivers may allow the switches 4a, 4b to be controlled by voltage levels found in transistor-transistor logic (TTL) or complementary metal-oxide-semiconductor (CMOS) logic. As such, operation of the switches 4a, 4b may for example be controlled by a microcontroller (not shown in Fig. 1). Using semiconductor switches 4a and 4b in the outputs of the power supply branches 2a and 2b is advantageous in that those switches may provide a low on-resistance (R_{DS(on)}) which is required to supply high-power external loads such as rear or front lamps in automotive applications for example.

Each power supply branch 2a, 2b in the example of Fig. 1 also comprises a first resistor 5a and 5b, respectively. A first end of the first resistor 5a, 5b is electrically connected to the electrical connection of the first semiconductor switch 3a, 3b and the second semiconductor switch 4a, 4b, respectively. A second end of the first resistor 5a, 5b is configured to be electrically connected to a reference potential which in the case of the example of Fig. 1 is ground. The electrical connection to the reference potential can be made via a plug connection, clamp, solder connection or the like. In addition, the connection to ground may be switched off by another semiconductor switch (not shown in the figures) to prevent current flow in a power safe mode to reduce quiescent current. Power safe mode may be a non-safety critical mode.

The first resistors 5a and 5b may have exemplary values of 10 kΩ, but other values may be used as well depending on application. Also, the values of the resistors 5a and 5b are conveniently the same, but this is not required.

During nominal operation of the power supply circuit 1 one power supply branch, for example 2a, is always active and the other branch, for example 2b is switched off. To this end, the first and second semiconductor switches 3a and 4a in the first branch 2a are switched on and the first and second semiconductor switches 3b and 4b in the second branch 2b are switched off. If the power source supplying the active branch 2a loses power, a controller or the like (not shown in Fig. 1) can deactivate the first branch 2a and activate the second branch 2b. Power loss can be sensed at the common output 3 of the power supply circuit 1: During normal operation, the nominal voltage (e.g. 12 V in an example) should be present at the output 3. In case of a power loss, the voltage will drop significantly.

In the example of Fig. 1 the power supply circuit 1 also comprises optional second resistors 6a and 6b between the connection of the first and second semiconductor switch and the common output 3 of the electrical power supply circuit 1. Thus, the first resistor 5a, 5b and the second resistor 6a, 6b form a voltage divider. In other embodiments, the second resistors 6a and 6b are absent.

Irrespective of whether the optional second resistors 6a, 6b are present, the output of a semiconductor switch 3a, 3b is pulled to a defined potential even if the corresponding switch is off, e.g. in a non-conducting state. This is caused by the first resistors 5a, 5b being connected to ground as shown in Fig. 1. Based thereon, a self-test of the power supply circuit 1 to meet certain safety goals can be performed as will be described in the following.

To ensure freedom from interference between both power supply branches 2a and 2b according to the Automotive Safety Integrity Level- (ASIL-) D, the following safety goals (SG) shall be met:
SG 1a: An overcurrent I_{max_KL30_x_short} for a time duration of tₛₕₒᵣₜ (hard shortcut) through both branches 2a, 2b at the same time shall be avoided.
SG 1b: An overcurrent I_{max_long_KL30_x_long} for a time duration of t_{long} (creeping shortcut) through both branches 2a, 2b the same time shall be avoided.
SG 2a: A reverse current I_{revmax_KL30_x_short} for tₛₕₒᵣₜ into the corresponding branch 2a, 2b shall be avoided.
SG 2b: A reverse current I_{revmax_KL30_x_long} for t_{long} into the corresponding branch shall be avoided.
SG3: Increased availability at the common output 3 (this target is usually less than ASIL-D, but can be as high as ASIL-D).

An exemplary value for tₛₕₒᵣₜ is 500 µs and an exemplary value for t_{long} is 100 ms. The values are in general application dependent. The same is true for the current values I_{max_KL30_x_short}, I_{max_long_KL30_x_long}, I_{revmax_KL30_x_short} and I_{revmax_KL30_x_long}.

To achieve the mentioned safety goals, the following self-test has to be followed to diagnose and mitigate erroneous components or similar failure cases. To this end, it is assumed that the power sources feeding the corresponding power supply branches 2a and 2b, respectively, are active voltage supplies with a similar voltage Uₐ and U_{b} of approximately the nominal batter voltage U_{batt}, respectively, during the diagnostic. For example, both voltage supplies may provide approximately 12V, i.e. Uₐ ≈U_{b} and U_{batt} = 12V. Accordingly, the voltage Uo at the common output 3 of the power supply circuit 1 would also be approximately at 12 V.

The following table shows a test for a drain-to-source short circuit of the semiconductor switches 3a, 3b, 4a and 4b in both power supply branches 2a and 2b. Of course, the test may be performed if more power supply branches are present and the switches are operated accordingly.

| Switch 3a gate | Switch 4a gate | Switch 3b gate | Switch 4b gate | U MP₁ | U MP2 | Diag. mode | Diag. result |
|---|---|---|---|---|---|---|---|
| Off | Off | On | On | 0 V | | Switch 3a/4a short check | Pass |
| Off | Off | On | On | U_{batt} | | Switch 3a/4a short check | Fail |
| On | On | Off | Off | | 0 V | Switch 3b/4b short check | Pass |
| On | On | Off | Off | | U_{batt} | Switch 3b/4b short check | Fail |

The table shows the states of the respective switches which are controlled by means of their gates in the example of Fig. 1, the expected potentials U at the points MP1 and MP2, respectively (see Fig. 1), in case of no failure ("pass") and failure ("fail"), as well as the failure modes ("diag. mode") that are supposed to be detected by the respective test case. It should be mentioned that the expected potentials of 0 V and U_{batt} are dependent on the actual nominal voltage and whether the optional resistors 6a and 6b are present. Moreover, the expected potentials may be dependent on the resistance values of the resistors. Thus, in other embodiments, the expected potentials may be different and the fail/pass criteria may be different as well.

The potentials at the test or measurement points MP1 and MP2 may be measured by means of an analog-to-digital converter (ADC) for example and a digital representation of the measured potential may be fed to a microcontroller performing and monitoring the self-test.

If in the test described above a failure is detected, all switches 3a, 3b, 4a and 4b shall be turned off to meet the safety goals SG2a and SG2b. The controller controlling the test shall detect and report the failure. Safety goal SG3 has a lower priority and will be violated.

By means of the following table a test for a proper open state of the switches 3a,3b, 4a and 4b, i.e. high drain-to-source impedance at open gate, is described:

| Switch 3a gate | Switch 4a gate | Switch 3b gate | Switch 4b gate | U MP3 | Diag. mode | Diag. result |
|---|---|---|---|---|---|---|
| Off | Off | On | On | U_{batt} | Switch 3a/4a open check | Pass |
| Off | Off | On | On | 0 V | Switch 3a/4a open check | Fail |
| On | On | Off | Off | U_{batt} | Switch 3b/4b open check | Pass |
| On | On | Off | Off | 0 V | Switch 3b/4b open check | Fail |

The table shows the states of the respective switches which are controlled by means of their gates in the example of Fig. 1, the expected potential U at the point MP3 at the common output 3 (see Fig. 1) in case of no failure ("pass") and failure ("fail"), as well as the failure modes ("diag. mode") that are supposed to be detected by the respective test case.

The potential at the test or measurement point MP3 may be measured by means of an analog-to-digital converter (ADC) for example and a digital representation of the measured potential may be fed to a microcontroller performing and monitoring the self-test.

The test result shall be considered "valid" only if the corresponding output voltage at the common output 3 corresponds to the nominal voltage U_{batt}, i.e. the voltage supplied by the power sources at the inputs of the power supply circuit 1, e.g. 12 V. The open mode test for the active power supply branch shall be performed all the time. The open mode test for the other power supply branch shall be performed once per ignition cycle in case of an exemplary automotive application of the power supply circuit according to the invention by switching over to the other power supply branch being inactive during normal operation. The test can also be repeated, if necessary, during operation. The duration for the check of the corresponding voltage rail shall not exceed the fault tolerant time interval (FTTI), i.e. the test needs to be finished within FTTI in case the other power supply branch has the failure mode "open". The open mode test and the short mode tests could be performed at the same time.

In case of detected drain-to-source open failure, the failure shall be detected and reported by a controller conducting the test. In addition, if the open failure is in the currently active power supply branch, one may switch over to the inactive power supply branch. Although SG3 will be violated in this case, it generally has a lower priority.

Additional measures can be taken in case of a detected failure. For example, a microcontroller controlling the self-test may set a test flag in case of a failure. The flag may indicate to which test case the failure belongs. If the power supply circuit 1 is installed in a vehicle, the start or restart of the vehicle may be inhibited. A restart may be inhibited after the end of the current driving cycle.

As described above, the safety goals SG 2a and SG 2b are satisfied by not switching on the switches 3a and 4a at the same time as switches 3b and 4b, i.e. only one of the power supply branches 2a and 2b is active, in combination with the self-test and safe state operation described above. The safety goals SG 1a and SG 1b are satisfied by the semiconductor switches 3a and 3b as follows: Assume the failure is a short cut to ground on the load side of the power supply circuit 1, e.g. due to a defect electronic component on the side of attached loads. In this case, a potential overcurrent (e.g. above 3A in an example, in a more specific example 20-25A) can be detected by the semiconductor switches 3a and 3b. To this end, and as described above, the switches 3a, 3b may comprise high-side drivers with overcurrent protection, e.g. e-fuses. The switches 3a, 3b may switch off in case of overcurrent within a predetermined time, e.g. within 100 µs or less. As an additional safety measure, the switches 3a and 3b may be of different types, e.g. to ensure freedom from inference (FFI) in ASIL-D.

The self-test of the power supply circuit 1 described above may be performed by a microcontroller or similar control unit. To this end, the method of diagnosing the electrical power supply circuit 1 as disclosed herein may be implemented in hardware or in software or may be implemented partly in hardware and partly in software. Hardware suitable for implementing a method and an apparatus according to the present invention include a central processing unit (CPU), a microcontroller, an application-specific integrated circuit (ASIC) or the like. A (full or partial) software implementation may include compiling source code to obtain machine readable instructions which, when executed, cause a computer, CPU, microcontroller or the like to perform all or part of the method steps described herein.

## Claims

1. Electrical power supply circuit (1) comprising at least two power supply branches (2a, 2b), wherein each power supply branch (2a, 2b) comprises:
a first semiconductor switch (3a, 3b) configured to be electrically connected to a power source;
a second semiconductor switch (4a, 4b) in series with the first semiconductor switch (3a, 3b) and electrically connected to a common output (3) of the electrical supply circuit (1); and
a first resistor (5a, 5b), wherein a first end of the first resistor (5a, 5b) is electrically connected to the electrical connection between the first semiconductor switch (3a, 4b) and the second semiconductor switch (4a, 4b) and a second end of the first resistor (5a, 5b) is configured to be electrically connected to a reference potential.

2. Electrical power supply circuit (1) according to claim 1, wherein each power supply branch (2a, 2b) further comprises a second resistor (6a, 6b) with a first end being electrically connected to the electrical connection between the first semiconductor switch (3a, 3b) and the second semiconductor switch (4a, 4b) and a second end being electrically connected to the common output (3) of the electrical power supply circuit (1) in order to form a voltage divider with the first resistor (5a, 5b).

3. Electrical power supply circuit (1) according to one of claims 1 or 2, wherein the first semiconductor switch (3a, 3b) and the second semiconductor switch (4a, 4b) are MOSFTEs.

4. Electrical power supply circuit (1) according to one of claims 1-3, wherein the first semiconductor switch (3a, 3b) and/or the second semiconductor switch (4a, 4b) comprises overcurrent protection.

5. Electrical power supply circuit (1) according to one of claims 2-4, further comprising a controller configured to:
switch the semiconductor switches (3a, 3b, 4a, 4b);
receive an electrical signal corresponding to the electrical potential (MP1, MP2) at the first end of the first resistor (5a, 5b), and/or
receive an electrical signal corresponding to the electrical potential (MP3) at the common output (3) of the electrical power supply circuit (1).

6. Electrical power supply circuit (1) according to claim 5, further comprising a measurement unit configured to measure the electrical potential (MP1, MP2) at the first end of the first resistor (5a, 5b) and/or the electrical potential (MP3) at the common output (3) of the electrical power supply circuit (1), wherein the measurement unit is electrically connected to the controller.

7. Electrical power supply circuit (1) according to one of claims 5 or 6, wherein the controller is configured to output a failure signal and/or to set a failure flag if the electrical potential (MP1, MP2) at the first end of the first resistor (5a, 5b) deviates from a first predetermined value by a first predetermined amount and/or if the electrical potential (MP3) at the common output (3) of the electrical power supply circuit (1) deviates from a second predetermined value by a second predetermined amount.

8. Electrical power supply circuit (1) according to one of claims 1-7, wherein the first semiconductor switch (3a, 3b) and the second semiconductor switch (4a, 4b) comprise a forward direction and an opposing reverse direction, wherein the forward direction of the first semiconductor switch (3a, 3b) is configured to be operated in the reverse direction and the second semiconductor switch (4a, 4b ) is configured to be operated in the forward direction.

9. Electrical power supply circuit (1) according to one of claims 1-8 comprising two power supply branches (2a, 2b).

10. Electrical power supply circuit (1) according to one of claims 1-9 being configured for an automotive application.

11. Method of diagnosing an electrical power supply circuit (1) according to one of claims 1-10, wherein the electrical power supply circuit (1) comprises at least two power supply branches (2a, 2b), and wherein the method comprises the steps:
switching off the first semiconductor switch (3a) and the second semiconductor switch (4a) in the first power supply branch (2a);
switching on the first semiconductor switch (3b) and the second semiconductor switch (4b) in the second power supply branch (2b); and
measuring an electrical potential (MP2) at the first end of the first resistor (5a) in the first power supply branch (2a).

12. Method of claim 11, further comprising the step:
diagnosing a failure in the first power supply (2a) branch if the measured electrical potential (MP1) at the first end of the first resistor (5a) deviates from a first predetermined value by a first predetermined threshold and/or if the electrical potential (MP1) at the first end of the first resistor (5a) matches a second predetermined value within a first predetermined tolerance; and
switching off all semiconductor switches (3a, 3b, 4a, 4b) in response to diagnosing a failure in the first power supply branch (2a).

13. Method of one of claims 11 or 12, further comprising the step:
measuring an electrical potential (MP3) at the common output (3) of the electrical power supply circuit (1).

14. Method of claim 13, further comprising the steps:
diagnosing a failure in the second power supply branch (2b) if the measured electrical potential at the common output of the electrical power supply circuit (1) deviates from a third predetermined value by a second predetermined threshold and/or
if the electrical potential (MP3) at the common output (3) of the electrical power supply circuit (1) matches a fourth predetermined value within a second predetermined tolerance; and
outputting a failure signal and/or setting a failure flag in response to diagnosing a failure in the second power supply branch (2b).

15. Computer program comprising instructions which, when executed by a computer, cause the computer to perform a method of one of claims 11-14.
